Europäisches Patentamt

European Patent Office

Office européen des brevets

(11) Veröffentlichungsnummer: **0 054 656**
**B1**

(19)

(12)                    EUROPÄISCHE PATENTSCHRIFT

(45) Veröffentlichungstag der Patentschrift:
09.04.86

(21) Anmeldenummer: 81108511.7

(22) Anmeldetag: 19.10.81

(51) Int. Cl.⁴: **C 30 B 13/12, C 30 B 29/06**

---

(54) **Verfahren zum tiegelfreien Zonenschmelzen.**

---

(30) Priorität: 19.12.80 DE 3048184

(43) Veröffentlichungstag der Anmeldung:
30.06.82 Patentblatt 82/26

(45) Bekanntmachung des Hinweises auf die Patenterteilung:
09.04.86 Patentblatt 86/15

(84) Benannte Vertragsstaaten:
**AT DE FR GB IT**

(56) Entgegenhaltungen:
**IBM TECHNICAL DISCLOSURE BULLETIN, Band 18, Nr. 2, Juli 1975, Seite 336 New York, U.S.A. V. SHARMA: "Semiconductor silicon substrate for high yield"**

(73) Patentinhaber: **Siemens Aktiengesellschaft, Berlin und München Wittelsbacherplatz 2, D-8000 München 2 (DE)**

(72) Erfinder: **Ludsteck, Alexander, Dr. Dipl.-Ing., Schumacherring 21, D-8000 München 83 (DE)**

---

## Beschreibung

Die vorliegende Erfindung bezieht sich auf ein Verfahren zum tiegelfreien Zonenschmelzen eines an seineen freien Enden gehaltenen Siliciumstabes, bei dem eine den Stab ringförmig umgebende Induktionsheizspule innerhalb des eine definierte Gasatmosphäre aufweisenden Rezipienten relativ zum Stab in Stabachsrichtung bewegt wird und bei dem als Gasatmosphäre ein Sauerstoff und Kohlenstoff enthaltendes Gas oder Gasgemisch verwendet wird.

Ein solches Verfahren ist beispielsweise bereits in "IBM Technical Disclosure Bulletin", Band 18, Nr. 2, Juli 1975, Seite 336 beschrieben worden. Mit einem solchen Verfahren läßt sich Silicium für Halbleiterbauelemente der Nachrichtentechnik herstellen. Es kombiniert die positiven Eigenschaften des tiegelgezogenen Siliciums mit denen des zonengeschmolzenen Siliciums. Die positiven Eigenschaften des tiegelgezogenen Siliciums ist der höhere Sauerstoffgehalt, der Vorteil des zonengeschmolzenen Siliciums ist höherer elektrischer Widerstand, größere Reinheit insbesondere von Schwermetallen, hohe Versetzungsfreiheit, Freiheit von Swirls und höhere Gleichmäßigkeit in der Dotierung. Der Sauerstoff wirkt hingegen als Getter in den Oberflächenbereichen der aus dem Silicium hergestellten integrierten Schaltungen. Hierbei zeigt der gezielt eingebrachte Sauerstoff den Effekt des "Internal Gettering".

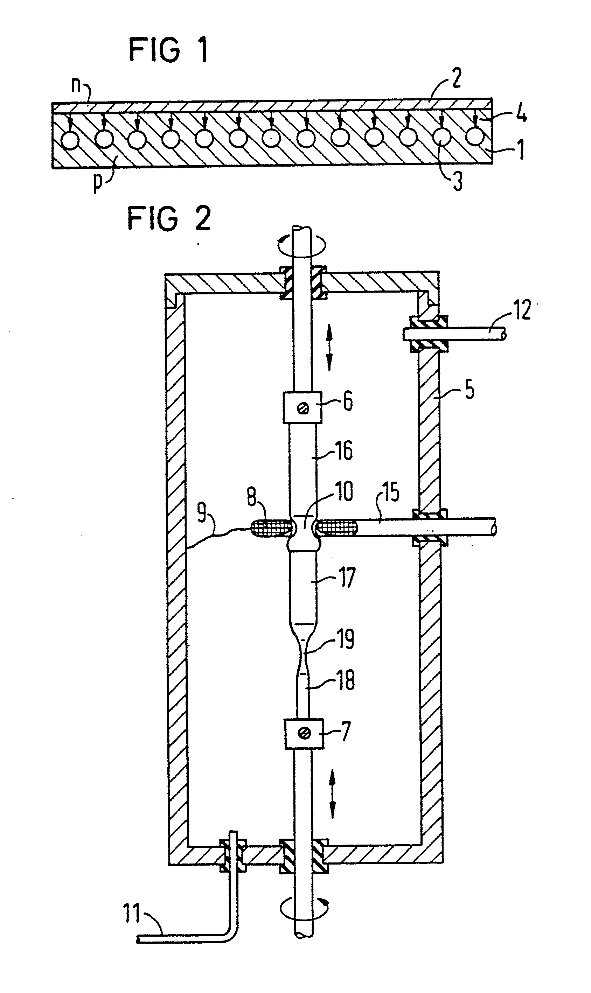

In Fig. 1 ist dieser Vorgang schematisch dargestellt. Das Siliciumplättchen 1 mit seinem oberflächennahen pn-Übergang 2 hat die durch Kreise symbolisch dargestellten Sauerstoffstörstellen 3. Durch die Pfeile 4 sind die Kräfte angedeutet, mit denen der Sauerstoff getternd auf seine Umgebung, insbesondere auf den für die einwandfreie Funktion wichtigen Bereiche der Oberflächenschicht und der angrenzenden Bereiche der Siliciumscheibe einwirkt. Die Sauerstoffstellen wirken als Senken für Verunreinigungen, insbesondere von Schwermetallen, die sich an den Stellen um den Sauerstoff herum ausscheiden. Auch konzentrieren sich die Swirls und andere komplizierte Gitterstörungen an dieser Stelle.

Der Einbau von Sauerstoff in das Silicium bewirkt starke Gitterspannungen, die durch das Einbringen von Kohlenstoff wieder ausgeglichen werden. Der Kohlenstoff kann dabei in etwa bis zur gleichen Menge wie der Sauerstoff eingebaut werden, ein Unterschied von einer Zehnerpotenz beeinflußt die Gitterneutralität kaum.

Es hat sich jedoch gezeigt, daß bei der Dotierung des schmelzflüssigen Siliciums mit Sauerstoff und einem Kohlenstoff enthaltenden Gas Reaktionsprodukte entstehen können, die die Eigenschaften des Siliciums nachteilig beeinflussen.

Der Erfindung liegt daher die Aufgabe zugrunde, ein Verfahren der erwähnten Art so weiterzubilden, daß ein nachteiliger Einfluß entstehender Reaktionsprodukte auf das Silicium vermieden wird.

Diese Aufgabe wird dadurch gelöst, daß der Partialdruck des Sauerstoffs auf einem Wert gehalten wird, der 2- bis 20 mal so groß wie der Dampfdruck des Siliciums bei Schmelztemperatur ist, daß der Partialdruck der den Kohlenstoff enthaltenden Komponente des auf einem Wert gehalten wird, der mindestens gleich groß wie der Dampfdruck des Siliciums bei Schmelzttemperatur ist, daß das Gas oder Gasgemisch der Schmelzzone als strömendes Gas zugeführt wird und daß die Stromungsgeschwindigkeit des Gases oder Gasgemisches so groß gewählt wird, daß entstehende Reaktionsprodukte aus dem Schmelzzonenbereich wegtransportiert werden.

Gemäß einer vorteilhaften Weiterbildung der Erfindung wird der Partialdruck des Sauerstoffs auf einen Wert kleiner als 1,5 bar, vorzugsweise zwischen 0,5 und 1,5 bar, eingestellt. Als Kohlenstoff enthaltendes Gas kann Kohlenmonoxid oder Kohlendioxid eingeführt werden, dem vorzugsweise ein Schutzgas zugemischt wird. Dieses Schutzgas, das Argon sein kann, wird dem Rezipienten entweder getrennt über eine eigene Zuleitung zugeführt oder dem Gasgemisch vor Einführung in den Rezipienten zugemischt. Die Reinheit der im Rezipienten verwendeten Gase sollten mindestens der Reinheit des herzustellenden Siliciums entsprechen. Gemäß einer besonders vorteilhaften Weiterbildung wird das Sauerstoff und Kohlenstoff enthaltende Gas oder Gasgemisch gegen die Schmelzzone geblasen. Hierbei wird die Geschwindigkeit direkt proportional dem im Rezipienten eingestellten Dampfdruck gewählt. Auch hierbei kann die Geschwindigkeit so groß gewählt werden, daß entstehende Reaktionsprodukte fortgeblasen werden.

In technisch einfacher Weise wird die Strömungsgeschwindigkeit des Sauerstoff und Kohlenstoff enthaltenden, Gases oder Gasgemisches durch eine oder mehrere Einzeldüsen oder durch eine Ringdüse eingestellt. Werden dabei die Düsen unterhalb der Schmelzzone angeordnet, so kann der Gasstrom zusätzlich mechanisch stabilisierend auf die Schmelzzone einwirken. Die Geschwindigkeit, mit der das Sauerstoff und Kohlenstoff enthaltende Gas oder Gasgemisch gegen die Schmelzzone geblasen wird, liegt dann zwischen 0,5 und 50 m/sec., vorzugsweise zwischen 30 und 50 m/sec.

Durch das Verfahren gemäß vorliegender Erfindung ist in technisch einfacher Weise die Herstellung von hochreinem, versetzungsarmen, einkristallinem Silicium möglich geworden mit einer Sauerstoff-Gesamtkonzentration von etwa $10^{16}$ bis $10^{20}$ Atome pro cm$^3$ vorzugsweise von $10^{18}$ bis $10^{19}$ Atome pro cm$^3$ und einer Kohlenstoff-Gesamtkonzentration von etwa $10^{15}$ bis $10^{18}$ Atome pro cm$^3$, vorzugsweise von $10^{17}$ bis $5.10^{17}$ Atome pro cm$^3$.

Die Erfindung wird anhand zweier als Ausführungsbeispiele zu wertenden Figuren näher erläutert.

In einem in Fig. 2 dargestellten, für das tiegelfreie Zonenschmelzen vorgesehenen Rezipienten 5 befindet sich ein senkrecht stehender, an seinen Enden in Halterungen 6 und 7 eingespannter Siliciumstab 16. Eine Heizeinrichtung, die aus einer mit Hochfrequenz gespeisten Induktionsheizspule 8 mit geerdeter Mittelanzapfung 9 besteht und an einem Träger 15 befestigt ist, erzeugt im Siliciumstab eine Schmelzzone 10, die den rekristallisierten Stabteil 17 von dem Stabteil 16 trennt und durch die Relativbewegung der Spule zum Stab längs des Stabes hindurchbewegt wird. In die Halterung 7 ist ein Keimkristall 18, der beispielsweise in (111)-Richtung orientiert ist, eingespannt; dieser weist zu mrekristallisierten Stabteil 17 hin eine flaschenhalsförmige Verengung 19 auf. Die Ziehgeschwindigkeit wird auf 4 mm/min. und die Rotationsgeschwindigkeit der Halterung 7 des wiedererstarrten Stabteils 17 auf 15 UpM eingestellt. Durch den Einlaß 11 wird ein Argon, Sauerstoff und Kohlenstoff enthaltendes Gasgemisch in das Innere des Reaktors 5 geleitet thermische Konvektion rund um die Schmelzzone in Verbindung mit der gewählten Gasströmung und den eingestellten Partialdrücken von 1,3 bar für Sauerstoff, 1 bar für die den Kohlenstoff enthaltende Komponente des Gasgemisches und 0,7 bar für Argon bewirken einen gesteuerten Einbau von Sauerstoff und Kohlenstoff in das zonengezogene Silicium. Entstehende Siliciumoxidverbindungen werden durch den Gasstrom aus der Reaktionszone weggetragen und durch den Gasauslaß 12 abgefüt.

Siliciumoxidbeläge, erkennbar an auftretenden bräunlichen Schwaden, werden durch Erhöhung der Sauerstoff/Kohlenstoff-Strömungsgeschwindigkeit mit Sicherheit vermieden.

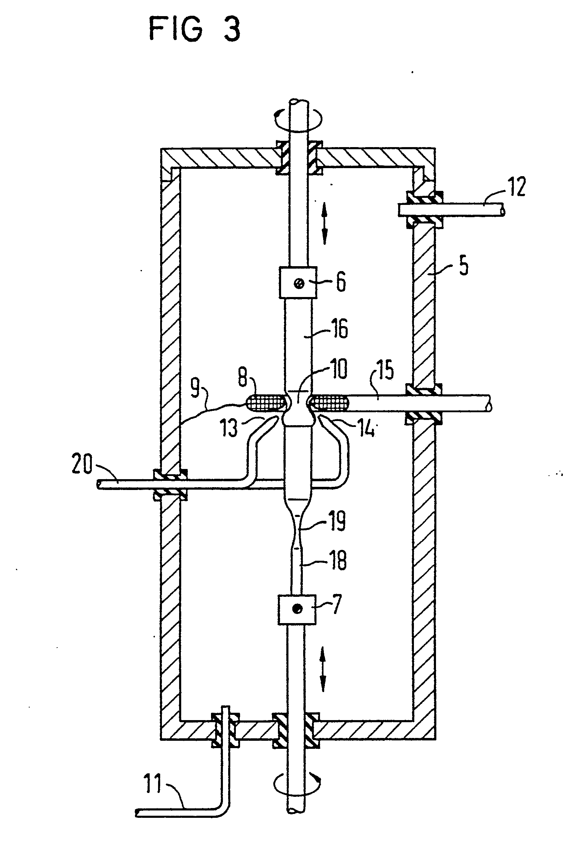

Falls höhere Sauerstoff- bzw. Kohlenstoffkonzentrationen im Silicium erwünscht sind, ist das in Fig. 3 dargestellte Verfahren wirkungsvoller. In dem Reaktionsgefäß 5 wird über den Einlaß 11 nur das Schutzgas Argon zugeführt, während über den Einlaß 20 zuströmendes reines Kohlendioxid vermöge der Einzeldüsen 13 und 14 gegen die Schmelzzone 10 mit einer Geschwindigkeit von beispielsweise 30 m/sec. geblasen wird. Die Einzeldüsen 13 und 14, die auch zu einer Ringdüse erweitert werden können, sind so unterhalb der Schmelzzone angeordnet, daß die Kohlendioxidströmung mechanisch stabilisierend auf die Schmelzzone einwirkt.

Reaktionsprodukte wie Siliciumoxid werden durch die Kohlendioxidströmung weggetragen und über den Auslaß 12 abgeführt.

**Patentansprüche**

1. Verfahren zum tiegelfreien Zonenschmelzen eines an sein freien Enden gehalterten Siliciumstabes, bei dem eine den Stab ringförmig umgebende Induktionsheizspule innerhalb des eine definierte Gasatmosphäre aufweisenden Rezipienten relativ zum Stab in Stabachsrichtung bewegt wird und bei dem als Gasatmosphäre ein Sauerstoff und Kohlenstoff enthaltendes Gas oder Gasgemisch verwendet wird, dadurch gekennzeichnet, daß der Partialdruck des Sauerstoffs auf einem Wert gehalten wird, der 2- bis 20 mal so groß wie der Dampfdruck des Siliciums bei Schmelztemperatur ist, daß der Partialdruck der den Kohlenstoff enthaltenden Komponente des Gases auf einem Wert gehalten wird, der mindestens gleich groß wie der Dampfdruck des Siliciums bei Schmelztemperatur ist, daß das Gas oder Gasgemisch der Schmelzzone als strömendes Gas zugeführt wird und daß die Strömungsgeschwindigkeit des Gases oder Gasgemisches so groß gewählt wird, daß entstehende Reaktionsprodukte aus dem Schmelzzonenbereich wegtransportiert werden.

2. Verfahren nach Anspruch 1, dadurch gekennzeichnet, daß der Partialdruck des Sauerstoffs auf einen Wert kleiner als 1,5 bar eingestellt wird.

3. Verfahren nach Anspruch 2, dadurch gekennzeichnet, daß der Partialdruck des Sauerstoffs auf einen Wert zwischen 0,5 und 1,5 bar eingestellt wird.

4. Verfahren nach einem der Ansprüche 1 bis 3, dadurch gekennzeichnet, daß als Gas Kohlenmonoxid in der Resipienten eingeführt wird.

5. Verfahren nach einem der Ansprüche 1 bis 3, dadurch gekennzeichnet, daß als Gas Kohlendioxid in den Resipienten eingeführt wird.

6. Verfahren nach einem der Ansprüche 1 bis 5, dadurch gekennzeichnet, daß dem Sauerstoff und Kohlenstoff enthaltenden Gas ein Schutzgas zugemischt wird.

7. Verfahren nach Anspruch 6, dadurch gekennzeichnet, daß dem Sauerstoff und Kohlenstoff enthaltenden Gas Argon zugemischt wird.

8. Verfahren nach Anspruch 7, dadurch gekennzeichnet, daß das Schutzgas getrennt über eine eigene Zuleitung dem Rezipienten zugeführt wird.

9. Verfahren nach Anspruch 7, dadurch gekennzeichnet, daß das Schutzgas dem Sauerstoff und Kohlenstoff enthaltenden Gas vor Einführung in den Rezipienten zugemischt wird.

10. Verfahren nach einem der Ansprüche 1 bis 9, dadurch gekennzeichnet, daß die Reinheit der im Rezipienten verwendeten Gase mindestens der Reinheit des herzustellenden Siliciums entspricht.

11. Verfahren nach einem der Ansprüche 1 bis 10, dadurch gekennzeichnet, daß das Sauerstoff und Kohlenstoff enthaltende Gas oder Gasgemisch gegen die Schmelzzone geblasen wird.

12. Verfahren nach einem der Ansprüche 1 bis 11, dadurch gekennzeichnet, daß die Geschwindigkeit des Sauerstoff und Kohlenstoff

enthaltenden Gases oder Gasgemisches direkt proportional dem im Rezipienten eingestellten Dampfdruck gewählt wird.

13. Verfahren nach Anspruch 11 oder 12, dadurch gekennzeichnet, daß die Geschwindigkeit des auf die Schmelzzone gerichteten Gasstromes so groß gewählt wird, daß entstehende Reaktionsprodukte fortgeblasen werden.

14. Verfahren nach einem der Ansprüche 11 bis 13, dadurch gekennzeichnet, daß die Strömungsgeschwindigkeit des Sauerstoff und Kohlenstoff enthaltenden Gases oder Gasgemisches durch eine oder mehrere Einzeldüsen eingestellt wird.

15. Verfahren nach einem der Ansprüche 11 bis 14, dadurch gekennzeichnet, daß die Strömungsgeschwindigkeit des Sauerstoff und Kohlenstoff enthaltenden Gases oder Gasgemisches durch eine Ringdüse eingestellt wird.

16. Verfahren nach einem der Ansprüche 11 bis 15, dadurch gekennzeichnet, daß die Düsen so unterhalb der Schmelzzone angeordnet werden, daß ihr Gasstrom mechanisch stabilisierend auf die Schmelzzone einwirkt.

17. Verfahren nach einem der Ansprüche 11 bis 16, dadurch gekennzeichnet, daß das Sauerstoff und Kohlenstoff enthaltende Gas oder Gasgemisch mit einer Geschwindigkeit von 0,5 bis 50 m/s, vorzugsweise von 30 bis 50 m/s, gegen die Schmelzzone geblasen wird.

18. Verwendung des Verfahrens nach einem der Ansprüche 1 bis 17 zur Herstellung von hochreinem versetzungsarmen einkristallinem Silicium mit einer Sauerstoff-Gesamtkonzentration von etwa $10^{16}$ bis $10^{20}$ Atome pro cm³, vorzugsweise von $10^{18}$ bis $10^{19}$ Atome pro cm³, und einer Kohlenstoff-Gesamtkonzentration von etwa $10^{15}$ bis $10^{18}$ Atome pro cm³, vorzugsweise von $10^{17}$ bis $5. 10^{17}$ Atome pro cm³.

**Revendications**

1. Procédé pour la fusion en zone flottante sans creuset d'un barreau de silicium maintenu par ses extrémités libres, dans lequel une bobine de chauffage par induction qui entoure le barreau, à la manière d'un anneau est déplacée par rapport au barreau, dans le sens de l'axe de celui-ci, à l'intérieur d'un récipient contenant une atmosphère gazeuse definie, et dans lequel un gaz ou un mélange gazeux contenant de l'oxygène et du carbone est utilisé en tant que atmosphère gazeuse, caractérisé en ce que la pression partielle de l'oxygène est maintenue à une valeur qui est de 2 à 20 fois plus élevée que la tension de vapeur du silicium à la température de fusion, que la pression partielle du composant gazeux contenant le carbone est maintenue à une valeur au moins égale à la tension de vapeur du silicium à la température de fusion, que le gaz ou le mélange gazeux est amené à la zone fondue sous forme d'un gaz en écoulement et que la vitesse d'écoulement du gaz ou du mélange gazeux est choisie suffisamment grande pour que les produits réactionnels formés soient évacués de la région de la zone fondue.

2. Procédé selon la revendication 1, caractérisé en ce que la pression partielle de l'oxygène est réglée à moins de 1,5 bar.

3. Procédé selon la revendication 2, caractérisé en ce que la pression partielle de l'oxygène est réglée entre 0,5 et 1,5 bar.

4. Procédé selon une des revendications 1 à 3, caractérisé en ce que le gaz introduit dans le récipient est du monoxyde de carbone.

5. Procédé selon une des revendications 1 à 3, caractérisé en ce que le gaz introduit dans le récipient est du dioxyde de carbone.

6. Procédé selon une des revendications 1 à 5, caractérisé en ce qu'un gaz de protection est ajouté en mélange au gaz contenant de l'oxygène et du carbone.

7. Procédé selon la revendication 6 caractérisé en ce que de l'argon est ajouté en mélange au gaz contenant de l'oxygène et du carbone.

8. Procédé selon la revendication 7, caractérisé en ce que le gaz de protection est amené séparément au recipient, par une canalisation d'amenée qui lui est propre.

9. Procédé selon la revendication 7, caractérisé en ce que le gaz de protection est ajouté en mélange au gaz contenant de l'oxygène et du carbone avant l'introduction dans le récipient.

10. Procédé selon une des revendications 1 a 9, caractérisé en ce que la pureté des gaz utilisés dans le récipient correspond au moins à la pureté du silicium à fabriquer.

11. Procédé selon une des revendications 1 à 10, caractérisé en ce que le gaz ou le mélange gazeux contenant de l'oxygène et du carbone est soufflé contre la zone fondue.

12. Procédé selon une des revendications 1 à 11, caractérisé en ce que la vitesse du gaz ou du mélange gazeux contenant de l'oxygène et du carbone est directement proportionnelle à la tension de vapeur établie dans le récipient.

13. Procédé selon la revendication 11 ou 12, caractérisé en ce que la vitesse du courant gazeux dirigé sur la zone fondue est choisie si grande que des produits réactionnels qui se forment sont chassés par soufflage.

14. Procédé selon une des revendications 11 à 13, caractérisé en ce que la vitesse d'écoulement du gaz ou du mélange gazeux contenant de l'oxygène et du carbone est fixée par une ou plusieurs tuyères séparées.

15. Procédé selon une des revendications 11 à 14, caractérisé en ce que la vitesse d'écoulement du gaz ou du mélange gazeux contenant de l'oxygène et du carbone est fixée par une tuyère annulaire.

16. Procédé selon une des revendications 11 à 15, caractérisé en ce que les tuyères sont disposées audessous de la zone fondue de manière que leur courant gazeux exerce une

17. Procédé selon une des revendications 11 à 16, caractérisé en ce que le gaz ou le mélange gazeux contenant de l'oxygène et du carbone est soufflé contre la zone fondue avec une vitesse de 0,5 à 50 m/s, de préférence de 30 à 50 m/s.

18. Utilisation du procédé selon une des revendications 1 à 17 pour fabriquer du silicium monocristallin de grande pureté, pauvre en dislocations, présentant une concentration totale d'oxygène d'environ $10^{16}$ à $10^{20}$ atomes par $cm^3$, de préférence de $10^{18}$ à $10^{19}$ atomes par $cm^3$, et une concentration totale de carbone d'environ $10^{15}$ à $10^{18}$ atomes par $cm^3$, de préférenc de $10^{17}$ à $5.\,10^{17}$ atomes par $cm^3$.

**Claims**

1. A process for the floating zone melting of a silicon rod which is supported at its free ends, in which an induction heating coil which surrounds the rod in annular fashion is moved relative to the rod in the axial direction thereof within a container in which a predetermined gaseous atmosphere prevails, and in which a gas or gas mixture containing oxygen and carbon is used as the gaseous atmosphere, characterised in that the partial pressure of the oxygen is maintained at a value which is 2 to 20 times the vapour pressure of the silicon at the melting temperature; that the partial pressure of that component of the gas which contains the carbon is maintained at a value which is at least equal to the vapour pressure of the silicon at the melting temperature; that the gas or gas mixture is fed to the melting zone as a gas stream; and that the flow rate of the gas or gas mixture is selected to be such that reaction products produced are transported away from the region of the melting zone.

2. A process as claimed in Claim 1, characterised in that the partial pressure of the oxygen is set at a value of less than 1.5 bar.

3. A process as claimed in Claim 2, characterised in that the partial pressure of the oxygen is set at a value of between 0.5 and 1.5 bar.

4. A process as claimed in one of Claims 1 to 3, characterised in that carbon monoxide is introduced as gas into the container.

5. A process as claimed in one of Claims 1 to 3, characterised in that carbon dioxide is introduced as gas into the container.

6. A process as claimed in one of the Claims 1 to 5, characterised in that a shielding gas is mixed with the gas which contains oxygen and carbon.

7. A process as claimed in Claim 6, characterised in that argon is mixed with the gas which contains oxygen and carbon.

8. A process as claimed in Claim 7, characterised in that the shielding gas is supplied to the container separately through an individual supply line.

9. A process as claimed in Claim 7, characterised in that the shielding gas is mixed with the gas which contains oxygen and carbon before introduction into the container.

10. A process as claimed in one of Claims 1 to 9, characterised in that the purity of the gases used in the container corresponds at least to the purity of the silicon which is to be produced.

11. A process as claimed in one of Claims 1 to 10, characterised in that the gas or gas mixture which contains oxygen and carbon is blown towards the melting zone.

12. A process as claimed in one of Claims 1 to 11, characterised in that the speed of the gas or gas mixture which contains oxygen and carbon is selected to be directly proportional to the vapour pressure set in the container.

13. A process as claimed in Claim 11 or Claim 12, characterised in that the speed of the gas flow which is directed towards the melting zone is selected to be such that reaction products produced are blown away.

14. A process as claimed in one of Claims 11 to 13, characterised in that the flow rate of the gas or gas mixture which contains the oxygen and carbon is set by one or more individual nozzles.

15. A process as claimed in one of Claims 11 to 14, characterised in that the flow rate of the gas or gas mixture which contains oxygen and carbon is set by means of an annular nozzle.

16. A process as claimed in one of Claims 11 to 15, characterised in that the nozzles are arranged beneath the melting zone in such manner that the gas flow therefrom exerts a mechanically stabilising influence on the melting zone.

17. A process as claimed in one of Claims 11 to 16, characterised in that the gas or gas mixture which contains oxygen and carbon is blown towards the melting zone at a speed of 0.5 to 50 m/s, preferably 30 to 50 m/s.

18. The use of the process claimed in one of Claims 1 to 17 for the production of very pure, low-defect, monocrystalline silicon having an overall oxygen concentration of about $10^{16}$ to $10^{20}$ atoms per $cm^3$, preferably $10^{18}$ to $10^{19}$ atoms per $cm^3$, and an overall carbon concentration of about $10^{15}$ to $10^{18}$ atoms per $cm^3$, preferably $10^{17}$ to $5.\,10^{17}$ atoms per $cm^3$.

5

## FIG 1

n

2

4

p

3

1

## FIG 2

12

6

5

16

9

8

10

15

17

19

18

7

11

# FIG 3